# EUROPÄISCHE PATENTANMELDUNG

(11) **EP 2 574 687 A2**
(43) Veröffentlichungstag der Anmeldung: **03.04.2013**
(21) Anmeldenummer: 12199607.8
(22) Anmeldetag: 15.09.2010
(51) Int. Cl.: C25D 5/02, C25D 5/18, C25D 17/00, C25D 5/00, C25D 7/12, H01L 21/288, H01L 31/0224

(54) **Verfahren und Vorrichtung zur galvanischen Beschichtung von Substraten**

(30) Priorität: 17.09.2009 DE 102009029551
(62) Teilanmeldung aus: 10176929.7
(71) Anmelder: SCHOTT Solar AG, 55122 Mainz (DE)
(72) Erfinder: Lippert, Lothar, 65549 Limburg (DE); Dauwe, Stefan, 63825 Blankenbach (DE)
(74) Vertreter: Mehler Achler

(57) **Zusammenfassung**

Es wird eine Vorrichtung (10) zur galvanischen Beschichtung von mindestens einer Oberfläche (2, 3) mindestens eines Substrates (1), insbesondere einer Solarzelle (1a), beschrieben. Die Vorrichtung weist ein Beschichtungsbad (13) auf, das eine mit elektrolytischer Beschichtungsflüssigkeit (14) gefüllte Beschichtungswanne (2) aufweist. Ferner ist eine Transporteinrichtung (15) zum Durchführen des Substrates (1) durch das Beschichtungsbad (13), ein Lichtquellenschaltkreis (60) mit mindestens einer Lichtquelle (64) zur Bestrahlung des Substrates (1) und ein Gleichrichterschaltkreis (50) für das Substrat (1) vorgesehen. Die Vorrichtung weist Mittel zur Erzeugung von synchronen Stromimpulsen und Lichtimpulsen auf, wobei in den Impulspausen zwischen den Stromimpulsen die Bestrahlung des Substrates unterbrochen ist. Mittel zur Erzeugung einer Strömung der Beschichtungsflüssigkeit (14) sind vorgesehen, wobei diese Mittel eine Gegenstromeinrichtung umfassen, die die Beschichtungsflüssigkeit (14) in eine Strömung entgegen der Vorschubrichtung des Substrates (1 ) versetzt, wobei der Einlass (21) der Beschichtungswanne (12) am Ende und der Auslass (22) der Beschichtungswanne (12) am Anfang der Transporteinrichtung (15) angeordnet ist. Es wird auch ein Verfahren zur galvanischen Beschichtung von Oberflächen eines Substrates beschrieben.

## Beschreibung

Die Erfindung betrifft eine Vorrichtung zur galvanischen Beschichtung von mindestens einer Oberfläche mindestens eines Substrates gemäß dem Oberbegriff des Patentanspruchs 1.

Die Erfindung bezieht sich auch auf ein Verfahren zur galvanischen Beschichtung gemäß dem Oberbegriff des Patentanspruchs 8.

Aus der DE 10 2007 038 120 A1 ist eine gattungsgemäße Beschichtungsvorrichtung bekannt, in der Solarzellen mittels Transportrollen durch eine Beschichtungswanne bewegt werden, die ein Beschichtungsbad enthält. An der Unterseite der Wanne sind unterschiedliche Arten von Lichtquellen, z. B. LEDs angeordnet, deren Lichtwellenlänge an die jeweilige Beschichtungsflüssigkeit angepasst ist.

Die Beschichtung kann ausschließlich lichtinduziert aber auch stromunterstützt durchgeführt werden. Die Lichteinstrahlung mittels Leuchtmittel generiert eine Spannung an der Zelle, die einen Zellstrom in Gang setzt. Dieser Zellstrom initiiert eine Metallabscheidung aus dem entsprechend zusammengesetzten Beschichtungsbad auf die Vorderseite der Solarzelle. Die Solarzelle ist in dem Galvanikstromkreis, der als Gleichrichterbeschaltung bezeichnet wird, die Kathode.

Die kombinierte licht- und strominduzierte Beschichtung bewirkt jedoch keine signifikante Durchsatzsteigerung.

In der DE 42 25 961 A1 wird das Arbeiten mit konstanter Gleichspannung im Galvanikstromkreis als nachteilig angesehen. Die zu galvanisierenden Gegenstände befinden sich auf dem Weg durch das Beschichtungsbad im Wesentlichen in demselben elektrischen Feld. Die Plattiergeschwindigkeit, also die Geschwindigkeit, mit der sich die abgeschiedene Metallschicht auf den Substraten aufbaut, ist aber verhältnismäßig gering. Dies bedeutet, dass bei einer vorgegebenen Bewegungsgeschwindigkeit der Gegenstände die Länge der Vorrichtung sehr groß sein muss.

Um das Ziel einer höheren Plattiergeschwindigkeit zu erreichen, wird in der DE 42 25 961 A1 vorgeschlagen, den Galvanikschaltkreis, d. h. die Gleichrichterbeschaltung, mit Strompulsen zu betreiben. Es hat sich herausgestellt, dass mit dieser Maßnahme die Plattiergeschwindigkeit um ein Vielfaches erhöht werden kann. Die stromlosen Zeiten, die zwischen den Stromimpulsen liegen, werden dadurch kompensiert, dass die Amplitude der Stromimpulse entsprechend erhöht wird.

Aufgabe der Erfindung ist es, den Durchsatz an Substraten in der Beschichtungsvorrichtung weiter zu erhöhen.

Die Aufgabe wird mit einer Vorrichtung gemäß Anspruch 1 und einem Verfahren gemäß Anspruch 8 gelöst.

Die Vorrichtung ist dadurch gekennzeichnet, dass Mittel zur Erzeugung von synchronen Stromimpulsen und Lichtimpulsen vorgesehen sind, wobei in den Pausen zwischen den Stromimpulsen die Bestrahlung des Substrates unterbrochen ist.

Es hat sich gezeigt, dass der Durchsatz gesteigert werden kann, wenn nicht nur mit Stromimpulsen, sondern auch mit zu den Stromimpulsen synchronen Lichtimpulsen gearbeitet wird. Synchrone Impulse bedeutet, dass die Lichtimpulse immer dann anliegen, wenn auch die Stromimpulse anliegen. In den Pulspausen zwischen den Stromimpulsen liegen auch die Pulspausen der Lichtimpulse. Zur Unterbrechung der Bestrahlung der zu beschichtenden Substratoberfläche kann beispielsweise die Lichtquelle abgeschaltet werden. Auch eine Abschattung der Lichtquelle in den Pausen ist möglich. Als Lichtquellen werden bevorzugt LEDs verwendet.

Mit solchen synchronen Lichtimpulsen konnte die Plattiergeschwindigkeit gegenüber einer Dauerbeleuchtung gemäß der DE 10 2007 038 10 A1 nochmals erhöht werden. Vorzugsweise umfassen die Mittel zur synchronen Erzeugung von Stromimpulsen und Lichtimpulsen mindestens einen Impulsgenerator in dem Gleichrichterschaltkreis und/oder in dem Lichtquellenschaltkreis.

Der Gleichrichterschaltkreis und/oder der Lichtquellenschaltkreis sind vorzugsweise an den Impulsgenerator angeschlossen.

Es kann vorzugsweise ein Impulsgenerator vorgesehen sein, an dem beide Schaltkreise angeschlossen sind. Auch kann in jedem Schaltkreis ein eigener Impulsgenerator vorgesehen sein, die zur Erzeugung von synchronen Impulsen entsprechend zusammengeschaltet sind.

Vorzugsweise ist der Lichtcluellenschaftkreis über einen Optokoppler mit dem Gleichrichterschaltkreis gekoppelt. Die Kopplung über einen Optokoppler hat aufgrund der galvanischen Trennung von Eingang und Ausgang den Vorteil, dass Störeinflüsse aus einem Schaltkreis nicht auf den anderen Schaltkreis übertragen werden können. Die Verknüpfung der Schaltkreise über einen Optokoppler hat somit den Vorteil einer größeren Stabilität und Gleichmäßigkeit der erzeugten Impulse.

Gemäß einer weiteren Ausführungsform weist der Lichtquellenschaltkreis und/oder Gleichrichterschaltkreis mindestens eine Steuereinrichtung auf, die in Abhängigkeit der Länge der Stromimpulse und/oder der Lichtimpulse die Lichtleistung der Lichtquelle und/oder die Stärke der Stromimpulse steuert. Mittels der mindestens einen Steuereinrichtung kann über die Stärke der Lichtimpulse und/oder der Stromimpulse die Morphologie der abgeschiedenen Metallschichten beeinflusst werden. Es können gradierte Metallschichten mit optimierten Eigenschaften abgeschieden werden. Eine weitere Möglichkeit besteht z. B. darin, die Stärke sowohl der Lichtimpulse als auch die der Stromimpulse gleichzeitig zu ändern, indem z. B. die Stromimpulse während der Beschichtung abgesenkt und die Lichtimpulse gleichzeitig erhöht werden.

Um die Abscheidegeschwindigkeit und somit den Durchsatz weiter zu erhöhen, sind vorzugsweise Mittel zur Erzeugung einer Strömung der Beschichtungsflüssigkeit vorgesehen. Da die Substrate durch die ruhende Beschichtungsflüssigkeit bewegt werden, ist eine Strömung an den Oberflächen des Substrates bereits vorhanden. Mit den Mitteln soll die Beschichtungsflüssigkeit ebenfalls in Strömung versetzt werden, so dass zu der aufgrund der Substratbewegung bereits vorhandenen Strömung eine zusätzliche Strömung an der Oberfläche des Substrates erzeugt wird.

Der Durchsatz kann zwar dadurch erhöht werden, dass die Stromdichte erhöht wird, z. B. durch die Stärke der Stromimpulse, weil dadurch die zu erreichende Schichtdicke schneller abgeschieden wird. Die Stromdichte kann aber nicht beliebig hoch gewählt werden, weil die so genannte Grenzstromdichte beachtet werden muss. Unter der Grenzstromdichte versteht man die Stromdichte, bei der die freie Metallionenkonzentration an der zu beschichtenden Kathoden-oberfläche, gegen Null geht.

Bei Überschreiten der Grenzstromdichte wird in diesem Bereich aufgrund der Verarmung an Metallionen in dem Elektrolyten gasförmiger Wasserstoff erzeugt, der in der bereits abgeschiedenen Metallschicht u. a. Poren erzeugt mit der Folge, dass die Morphologie der Metallschicht beeinträchtigt wird, was zur Pulverisierung der Metallschicht führen kann.

Es hat sich gezeigt, dass die Grenzstromdichte umso höher liegt, je höher die Strömungsgeschwindigkeit vₛ der Beschichtungsflüssigkeit an der Oberfläche der Kathodenfläche des Substrates ist.

Gemäß einer ersten Ausführungsform der Mittel zur Erzeugung der Strömung der Beschichtungsflüssigkeit ist mindestens eine Düse zum Einleiten von Beschichtungsflüssigkeit vorgesehen. Mittels der oder den Düsen wird die Beschichtungsflüssigkeit in eine turbulente Strömung versetzt, die vorzugsweise so groß gewählt wird, dass sie die durch den Vorschub des Substrates durch die Beschichtungsflüssigkeit an der zu beschichtenden Oberfläche bewirkte Strömung überwiegt oder verstärkt.

Vorzugsweise ist die Düse im Beschichtungsbad gegenüber der zu beschichtenden Oberfläche angeordnet.

Die Düse ist vorzugsweise senkrecht auf die zu beschichtende Oberfläche des Substrates gerichtet. Es wird dadurch eine Strömung auf die zu beschichtende Oberfläche des Substrates gerichtet, so dass beim Auftreffen der Strömung auf das Substrat Wirbel erzeugt werden. Diese Wirbel sollten an der Oberfläche des Substrates eine Geschwindigkeit besitzen, die größer ist als die durch den Vorschub des Substrates bedingte Relativgeschwindigkeit der Beschichtungsflüssigkeit.

Vorzugsweise ist die Düse zwischen den Anoden des Gleichrichterschaltkreises angeordnet. Die aus den Düsen auftretende Beschichtungsflüssigkeit kann ungehindert zu der zu beschichtenden Oberfläche strömen und wird nicht durch die Anoden abgeschwächt.

Die Düse ist vorzugsweise eine Venturidüse, mit der eine hohe Austrittsgeschwindigkeit der Beschichtungsflüssigkeit erzielt werden kann.

Gemäß einer zweiten Ausführungsform umfassen die Mittel zur Erzeugung der Strömung der Beschichtungsflüssigkeit eine Umwälzeinrichtung.

Diese Umwälzeinrichtung ist vorzugsweise eine Gegenstrom-einrichtung. Die Gegenstromeinrichtung versetzt die Beschichtungs-flüssigkeit in eine Strömung, die entgegen der Vorschubrichtung des Substrates in dem Beschichtungsbad gerichtet ist. Der Einlass der Beschichtungswanne ist vorzugsweise am Ende und der Auslass der Beschichtungswanne am Anfang der Transporteinrichtung angeordnet. Die Beschichtungsflüssigkeit wird somit vorzugsweise entgegen der Vorschubrichtung aus der Beschichtungswanne abgesaugt. Vorzugsweise sind Ein- und Auslass in der Höhe der Transporteinrichtung, d. h. in der Höhe der zu transportierenden Substrate angeordnet, damit die Gegenströmung durch die übrigen Einbauten im Beschichtungsbad nicht behindert wird.

Die Einrichtung mit Düsen kann ebenso alleine eingesetzt werden wie die Umwälzeinrichtung. Es ist jedoch bevorzugt, beide Einrichtungen in Kombination vorzusehen.

Das Verfahren zur galvanischen Beschichtung von mindestens einer Oberfläche eines Substrates ist dadurch gekennzeichnet, dass der Galvanikstrom und das Licht synchron gepulst werden, wobei in den Impulspausen zwischen den Stromimpulsen die Bestrahlung des Substrates unterbrochen wird.

Die Länge der Licht- und Stromimpulse beträgt vorzugsweise 0,1 ms bis 10000 ms. Bevorzugte Impulslängen sind 1 ms - 1000 ms, insbesondere 1 ms bis 100 ms.

Die Länge der Impulse wird vorzugsweise gleich der Länge der Impulspausen gewählt.

Die Stromimpulse und/oder die Lichtimpulse sind vorzugsweise Rechteckimpulse.

Die Stärke und/oder die Länge der Lichtimpulse und/oder der Stromimpulse kann verändert werden. Die Veränderung der Impulse ermöglicht die Abscheidung von z. B. gradierten Metallschichten mit optimierten Eigenschaften. Mittels der/den Steuereinrichtung/en lassen/lässt sich auf diese Weise individuelle Galvanisierungs-programme realisieren.

Es hat sich gezeigt, dass es vorteilhaft ist, die Lichtimpulse umso schwächer zu wählen, je länger die Lichtimpulse sind. So kann beispielsweise die Lichtleistung 10 % der Maximallichtleistung betragen, wenn die Impulslänge 100 ms beträgt, 20 % bei einer Impulslänge von 1 ms und 80 % bei einer Impulslänge von 0,5 ms.

Zur weiteren Verbesserung des Durchsatzes kann in den Pausen der Stromimpulse ein Gleichstrom angelegt werden, dessen Stärke vorzugweise I₂ ≤ 0,5 x I₁, wobei I₁ die Stärke der Stromimpulse bezeichnet. Die Stromstärke I₂ wird vorzugsweise so niedrig gewählt, dass die notwendige Regenerierung der elektrolytischen Beschichtungsflüssigkeit bzgl. der Metallionenkonzentration an der zu beschichtenden Kathodenfläche nicht beeinträchtigt wird.

Die Beschichtungsflüssigkeit wird vorzugsweise mindestens im Bereich der zu beschichtenden Oberfläche des Substrates in eine zur Vorschubrichtung des Substrates entgegengesetzte Strömung versetzt.

Zusätzlich zu dieser entgegengesetzten Strömung oder auch unabhängig von einer entgegengesetzten Strömung kann die Beschichtungsflüssigkeit mindestens im Bereich der zu beschichtenden Oberfläche des Substrates in Turbulenzen versetzt werden.

Beispielhafte Ausführungsformen der Erfindung werden nachfolgend anhand der Zeichnungen näher erläutert.

Es zeigen:
- Fig. 1: einen schematischen Vertikalschnitt durch eine Beschichtungswanne,
- Fig. 2: eine schematische Darstellung der Schaltkreise und der Anordnung der Lichtquelle,
- Fig. 3: eine weitere Ausführungsform der Schaltkreise,
- Fig. 4 und 5: verschiedene Impulsdiagramme zur Erläuterung des Beschichtungsverfahrens.

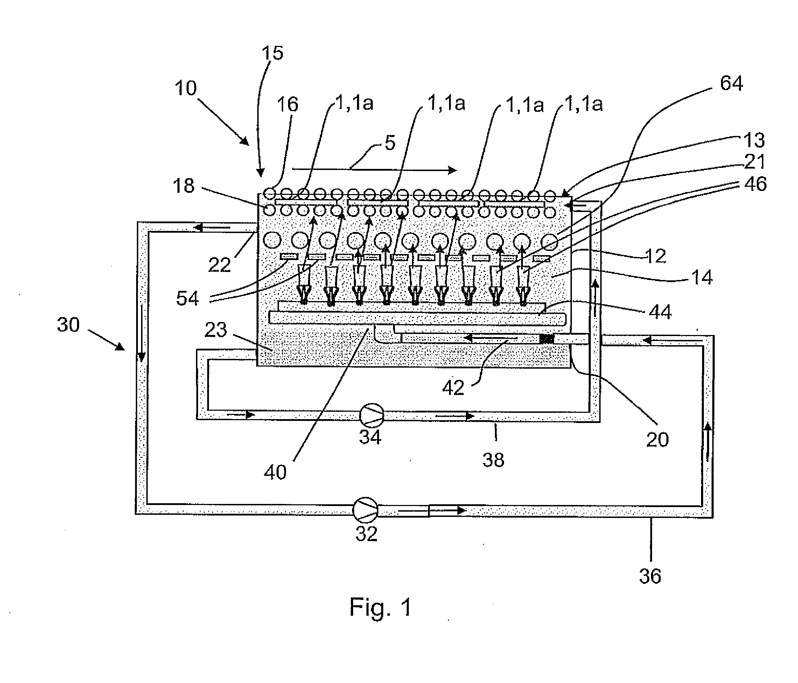

In der Fig. 1 ist schematisch ein Schnitt durch eine Vorrichtung 10 zur Beschichtung von Substraten 1 dargestellt. Als Substrate 1 werden in dem vorliegenden Beispiel Solarzellen 1a verwendet. Die Vorrichtung 10 umfasst eine Beschichtungswanne 12, die ein Beschichtungsbad 13 enthält, das aus einer elektrolytischen Beschichtungsflüssigkeit 14 gebildet wird.

Im oberen Bereich der Beschichtungswanne 12 ist eine Transporteinrichtung 15 vorgesehen, die obere Transportrollen 16 und untere Transportrollen 18 umfasst, zwischen denen die Solarzellen 1a gehalten und in Pfeilrichtung 5 transportiert werden. Die Beschichtungswanne 12 ist soweit mit der Beschichtungsflüssigkeit 14 gefüllt, dass sich die zu beschichtenden Solarzellen 1a vollständig in dem Beschichtungsbad 13 befinden.

Zur Erzeugung einer Strömung im Beschichtungsbad 13 ist eine Umwälzeinrichtung 30 vorgesehen, die eine erste Flüssigkeitsleitung 36 aufweist. Die Beschichtungswanne 12 weist unterhalb der Transporteinrichtung 15 einen ersten Auslass 22 auf, an dem die erste Flüssigkeitsleitung 36 angeschlossen ist. Mittels einer in dieser ersten Flüssigkeitsleitung 36 angeordneten ersten Pumpe 32 wird die Beschichtungsflüssigkeit 14 aus der Beschichtungswanne 12 über den ersten Auslass 22 abgepumpt und über einen ersten Einlass 20, der im Bodenbereich der Beschichtungswanne 12 angeordnet ist, der Beschichtungswanne 12 wieder zugeführt.

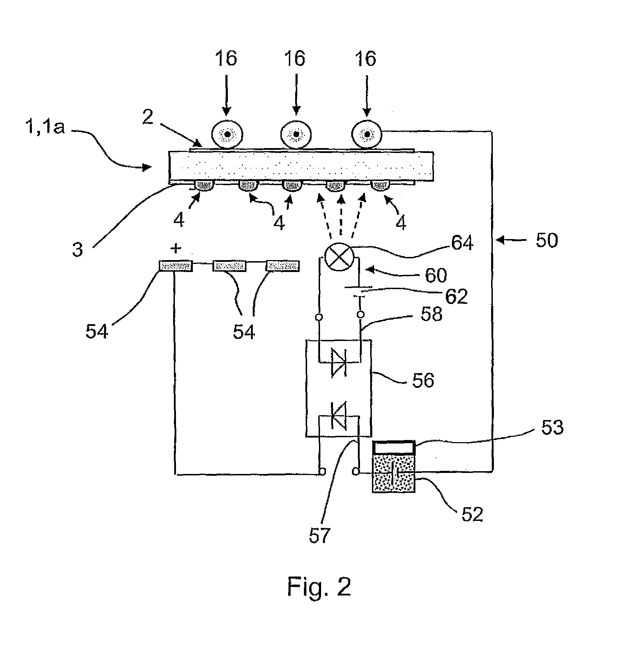

Im Innern der Beschichtungswanne 12 ist ein Einströmsystem 40 mit einem Zuführrohr 42 an die erste Flüssigkeitsleitung 36 angeschlossen. Am anderen Ende des Zuführrohrs 42 ist ein horizontal angeordnetes Verteilerrohr 44 angeschlossen, an dem eine Mehrzahl von Venturidüsen 46 angeordnet ist. Diese Venturidüsen 46 sind vertikal ausgerichtet und somit senkrecht zu den Solarzellen 1 a angeordnet. Aus diesen Venturidüsen 46 tritt die zugeführte Beschichtungsflüssigkeit mit hoher Geschwindigkeit aus und trifft somit im Wesentlichen senkrecht auf die zu beschichtende nach unten weisende Vorderseite 3 der Solarzellen 1 a auf (s. Fig. 2).

Damit diese Strömung nicht durch Einbauten gestört wird, sind diese Venturidüsen 46 zwischen den Anoden 54 des Gleichrichterschalt-kreises 50 angeordnet (s. Fig. 2). Oberhalb der Anoden 54 sind Lichtquellen 64 eingezeichnet, die LED-Lichtleisten sind. Die Anordnung der Lichtleisten ist lediglich schematisch dargestellt. Insbesondere an der Oberfläche 3 der Solarzellen 1a führt diese von unten kommende Strömung zu Turbulenzen, so dass die Beschichtungsflüssigkeit 14 sich im Bereich der zu beschichtenden Oberfläche 3 in den Impulspausen schnell regenerieren kann.

Um zusätzlich eine Strömung entgegen der Vorschubrichtung 5 innerhalb des Beschichtungsbades zu erzeugen besitzt die Beschichtungswanne 12 im linken unteren Bereich einen zweiten Auslass 23, an den eine zweite Flüssigkeitsleitung 38 mit einer zweiten Pumpe 34 angeschlossen ist. Diese Leitung 38 mündet in einem zweiten Einlass 21 im oberen Bereich der Beschichtungswanne 12 ein. Der zweite Einlass 21 befindet sich im Bereich der Solarzellen 1a, so dass zwischen dem zweiten Einlass 21 und dem ersten Auslass 22 eine horizontale Strömung entgegen der Vorschubrichtung 5 erzeugt wird.

Die Vorrichtung 10 kann beispielsweise auch ohne die zweite Flüssigkeitsleitung 38 ausgestattet sein. Eine weitere Variante kann ohne Einströmsystem 40 mit und ohne zweiter Flüssigkeitsleitung 38 ausgelegt sein. In der Ausführungsform ohne zweite Flüssigkeitsleitung 38 ist vorzugsweise die erste Flüssigkeitsleitung 36 am zweiten Einlass 21 an die Beschichtungswanne 12 angeschlossen.

In der Fig. 2 ist eine Solarzelle 1 a im Schnitt vergrößert dargestellt. Diese besitzt auf der Rückseite 2 eine Metallisierung und an der Vorderseite 3 für die Ausbildung von Kontaktfingern Streifen aus einer geeigneten Paste 4. Zur Ausbildung der Elektrodenstrukturen werden vorzugsweise Siebdruckpasten verwendet. Bei der galvanischen Abscheidung wird nur im Bereich dieser Siebdruckpasten das Metall aus der elektrolytischen Beschichtungsflüssigkeit abgeschieden.

Die oberen Transportrollen 16 kontaktieren die metallische Rückseite 2 der Solarzelle 1 a und können somit zum Anlegen eines Galvanikstromes genutzt werden. Hierzu ist ein Gleichrichterschaltkreis 50 vorgesehen, der eine der obere Transportrollen 16 mit den Anoden 54, die vorzugsweise Silberanoden sind, verbindet. In dem Gleichrichterschaltkreis 50 befindet sich eine Spannungsquelle 52 und ein Impulsgenerator 53. Mittels des Impulsgenerators 53 können Stromimpulse an die Solarzelle 1a und die Anoden 54 angelegt werden.

Ferner ist zur Bestrahlung der zu beschichtenden Oberfläche 3 stellvertretend für eine Mehrzahl von Lichtquellen eine Lichtquelle 64, z. B. eine LED, eingezeichnet. Diese Lichtquelle 64 ist an einen Lichtquellenschaltkreis 60 angeschlossen, der eine Spannungsversorgung 62 aufweist.

Die beiden Schaltkreise 50 und 60 sind über einen Optokoppler 56 miteinander verbunden, wobei der Eingang 57 des Optokopplers 56 an den Gleichrichterschaltkreis 50 angeschlossen ist und der Ausgang 58 an den Lichtquellenschaltkreis 60.

Der Optokoppler 56 ist in der Weise geschaltet, dass bei Anlegen eines Stromimpulses auch gleichzeitig die Lichtquelle 64 eingeschaltet wird, so dass auch gleichzeitig ein Lichtimpuls erzeugt wird. In den Stromimpulspausen wird die Lichtquelle 64 abgeschaltet.

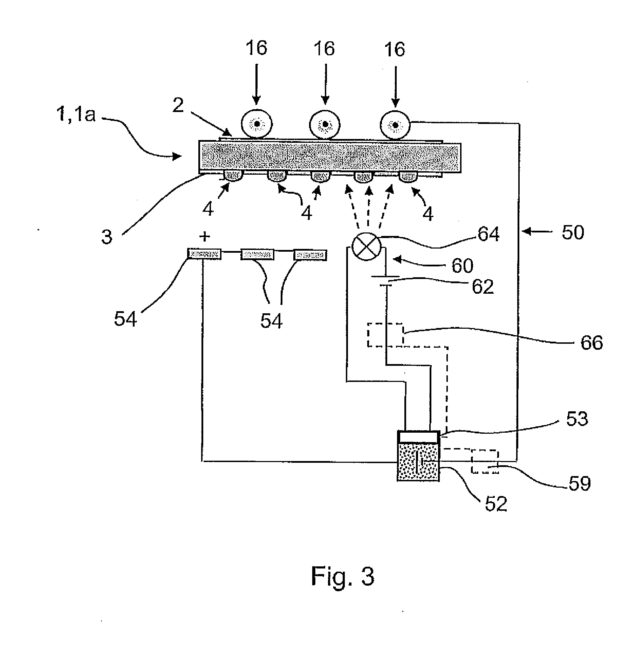

In der Fig. 3 ist eine weitere Ausführungsform dargestellt, bei der kein Optokoppler 56 vorgesehen ist. Stattdessen ist der Lichtquellenschaltkreis 60 unmittelbar an den Impulsgenerator 53 angeschlossen, der somit die Impulse für beide Schaltkreise 50, 60 vorgibt.

Optional kann noch eine Steuereinrichtung 66 im Lichtquellenschaltkreis 60 angeordnet sein. Diese Steuereinrichtung 66 kann die Lichtimpulsstärke beispielsweise in Abhängigkeit von der Länge der Impulse steuern.

Ebenso kann in dem Gleichrichterschaltkreis 50 eine Steuereinrichtung 59 vorgesehen sein, mit der unterschiedliche Längen und Höhen der Stromimpulse eingestellt werden. Mittels beider Steuereinrichtungen 59, 66 lässt sich ein vollautomatisches Galvanisierungsprogramm mit individuellen Beschichtungsstufen realisieren. Dies ist insbesondere von Vorteil, um gradierte Schichten auf den durch die Paste 4 definierten Elektrodenstrukturen auszubilden.

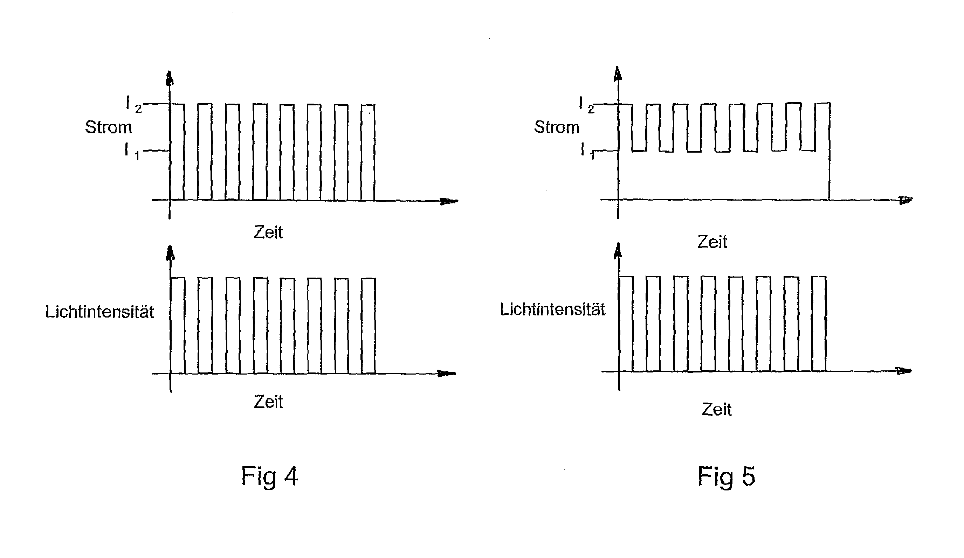

In der Fig. 4 sind zwei Diagramme bzgl. der Stromimpulse und der Lichtimpulse dargestellt. Die Lichtimpulse und die Stromimpulse sind gleich lang. Zwischen den Stromimpulsen bzw. den Lichtimpulsen sind Pausen vorgesehen, die gleich lang sind wie die Impulse. Die Licht- und Stromimpulse sind vollständig synchron, wobei in den Pulspausen die Lichtintensität null ist. Dies kann durch Abschalten der Lichtquelle oder durch eine Abschattung der Lichtquelle erreicht werden.

In der Fig. 5 ist eine weitere Ausführungsform dargestellt, in der in den Stromimpulspausen ein Gleichstrom angelegt wird, der die Stromstärke I₁ aufweist. Die Stromstärke I₁ beträgt 50 % der Stromstärke I₂. Die Lichtimpulse entsprechen denen aus der Fig. 4.

### Bezugszeichenliste

- 1: Substrat
- 1a: Solarzelle
- 2: Rückseite
- 3: Vorderseite
- 4: Paste
- 5: Vorschubrichtung

- 10: Vorrichtung
- 12: Beschichtungswanne
- 13: Beschichtungsbad
- 14: elektrolytische Beschichtungsflüssigkeit
- 15: Transporteinrichtung
- 16: obere Transportrolle
- 18: untere Transportrolle

- 20: erster Einlass
- 21: zweiter Einlass
- 22: erster Auslass
- 23: zweiter Auslass

- 30: Umwälzeinrichtung
- 32: erste Pumpe
- 34: zweite Pumpe
- 36: erste Flüssigkeitsleitung
- 38: zweite Flüssigkeitsleitung

- 40: Einströmsystem
- 42: Zuführrohr
- 44: Verteilerrohr
- 46: Venturidüse

- 50: Gleichrichterschaltkreis
- 52: Spannungsquelle
- 53: Impulsgenerator
- 54: Anode
- 56: Optokoppler
- 57: Eingang des Optokopplers
- 58: Ausgang des Optokopplers
- 59: Steuereinrichtung

- 60: Lichtquellenschaltkreis
- 62: Spannungsquelle
- 64: Lichtquelle, LED
- 66: Steuereinrichtung

## Patentansprüche

1. Vorrichtung zur galvanischen Beschichtung von mindestens einer Oberfläche (2, 3) mindestens eines Substrates (1), insbesondere einer Solarzelle (1a), mit einem Beschichtungsbad (13), das eine mit elektrolytischer Beschichtungsflüssigkeit (14) gefüllte Beschichtungswanne (12) aufweist, mit einer Transporteinrichtung (15) zum Durchführen des Substrates durch das Beschichtungsbad (13), mit einem Lichtquellenschaltkreis (60) mit mindestens einer Lichtquelle (64) zur Bestrahlung des Substrates (1) und mit einem Gleichrichterschaltkreis (50) für das Substrat (1) mit Anoden (54), **dadurch gekennzeichnet, dass**
Mittel zur Erzeugung von synchronen Stromimpulsen und Lichtimpulsen vorgesehen sind, wobei in den Impulspausen zwischen den Stromimpulsen die Bestrahlung des Substrates (1) unterbrochen ist, und
dass Mittel zur Erzeugung einer Strömung der Beschichtungsflüssigkeit (14) vorgesehen sind, wobei diese Mittel eine Gegenstromeinrichtung umfassen, die die Beschichtungsflüssigkeit (14) in eine Strömung entgegen der Vorschubrichtung des Substrates (1) versetzt, wobei der Einlass (21) der Beschichtungswanne (12) am Ende und der Auslass (22) der Beschichtungswanne (12) am Anfang der Transporteinrichtung (15) angeordnet ist.

2. Vorrichtung nach Anspruch 1, **dadurch gekennzeichnet, dass** die Mittel zur Erzeugung der Strömung der Beschichtungsflüssigkeit (14) mindestens eine Düse zum Einleiten von Beschichtungsflüssigkeit (14) umfassen.

3. Verfahren zur galvanischen Beschichtung von mindestens einer Oberfläche mindestens eines Substrates, wobei das Substrat durch eine elektrolytische Beschichtungsflüssigkeit bewegt und mit Licht bestrahlt wird, wobei an das Substrat mittels eines Gleichrichterschaltkreises ein Galvanikstrom angelegt wird, **dadurch gekennzeichnet,**
**dass** der Galvanikstrom und das Licht synchron gepulst werden, wobei in den Impulspausen zwischen den Stromimpulsen die Bestrahlung des Substrates unterbrochen wird, und
**dass** die Beschichtungsflüssigkeit mindestens im Bereich der zu beschichtenden Oberfläche des Substrates in eine zur Vorschubrichtung des Substrates entgegengesetzte Strömung versetzt wird.
